# EUROPEAN PATENT APPLICATION

(11) **EP 2 091 095 A2**
(43) Date of publication of application: **19.08.2009**
(21) Application number: 09152908.1
(22) Date of filing: 16.02.2009
(51) Int. Cl.: H01L 51/50

(54) **Organic electroluminescence element**

(30) Priority: 14.02.2008 JP 2008033516
(71) Applicant: Yamagata Promotional Organization for Industrial Technology, Yamagata-shi Yamagata 990-2473 (JP)
(72) Inventor: Oda, Atsushi c/o Yamagata Promotional Org. for Ind. Tech., Yamagata 990-2473 (JP); Kimura, Masato c/o Yamagata Promotional Org. for Ind. Tech., Yamagata 990-2473 (JP); Horiuchi, Takayuki c/o Yamagata Promotional Org. for Ind. Tech., Yamagata 990-2473 (JP)
(74) Representative: HOFFMANN EITLE

(57) **Abstract**

To find a triphenylbenzene derivative suitable for a wide-gap material which allows blue luminescence excellent in color purity, and provide an organic EL element using the same.

The organic EL element having one or a plurality of organic layers including a light emitting layer between a pair of electrodes is arranged such that at least one layer of the above-mentioned organic layers contains a compound as expressed by the following general formula (1) independently or as a mixture, 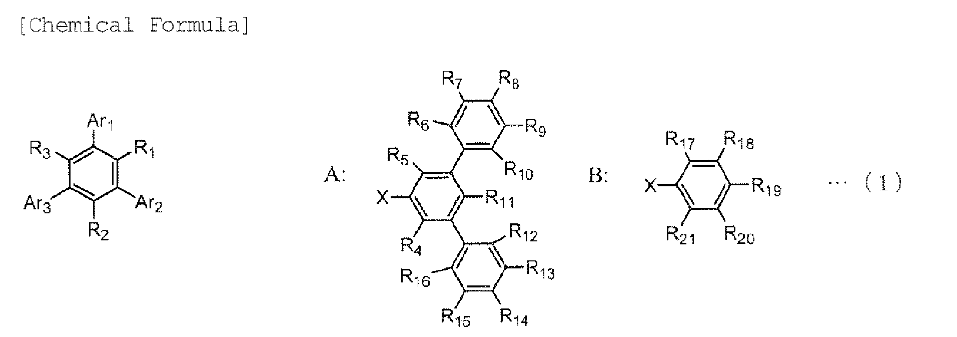 where R₁-R₂₁ are each independently selected from the group consisting of hydrogen, an alkyl group, a cycloalkyl group, an alkoxy group, a cycloalkoxy group, an aryloxy group, and an alkylsilyl group. Each of Ar₁-Ar₃ is A or B independently, and at least one of them is A. X indicates a bond part with respect to a central benzene ring and is bonded in a meta position with respect to the central benzene ring.

## Description

### BACKGROUND OF THE INVENTION

### Field of the Invention

The present invention relates to an organic electroluminescence element (hereinafter referred to as organic EL element) containing a m-phenylene derivative which allows a blue luminescent material to emit light with high color purity.

### Description of the Related Art

Since the organic EL element is a self-luminescence type element which includes an organic compound as a light emitting material and allows luminescence at a high speed, it is suitable for displaying a video image, and it has features that allow an element structure to be simple and a display panel to be thin. Having such outstanding features, the organic EL element is spreading in everyday life as a cellular phone display or a vehicle-mounted display.

Further, unlike LED, taking advantage of the features that it allows planar luminescence and is thin and lightweight, technical development as an illumination panel light source has also been carried out.

In the above-mentioned organic EL element, a wide-gap material is one of important materials in order to efficiently obtain fluorescence or phosphorescence luminescence from blue to red. Especially, in order to obtain a white-light emitting element with high color rendering properties, the wide-gap material that can take blue luminescence from a blue luminescent material with high color purity is particularly important.

As candidates for the wide-gap material for blue luminescence, there may be mentioned, for example, an anthracene derivative as shown in the following [Chemical Formula 1], a naphthalene derivative as shown in the following [Chemical Formula 2], a distyrylarylene derivative as shown in the following [Chemical Formula 3], etc. Further, there may be mentioned a phenylene derivative as shown in the following [Chemical Formula 4] (see Japanese Patent Application Publication No. 2004-534865, International Publication WO 2005/032216), a carbazole derivative as shown in the following [Chemical Formula 5] (see International Publication WO 2005/072017), etc.

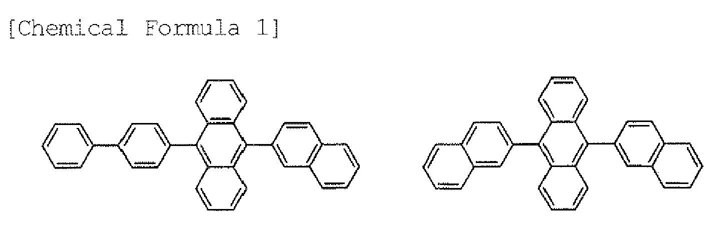

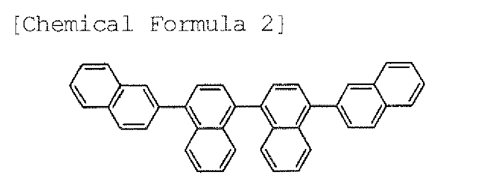

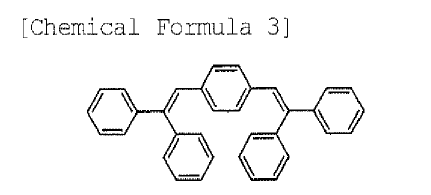

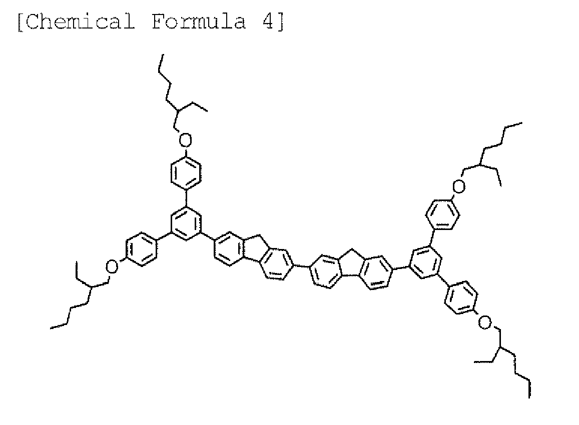

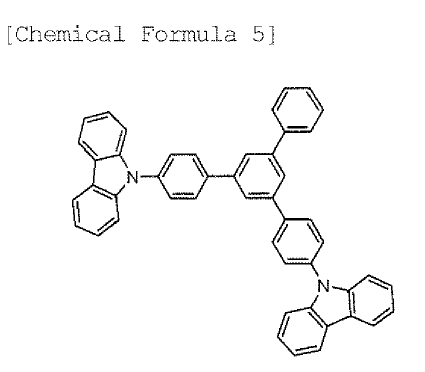

However, such materials do not have a sufficient energy gap to be used for a blue light emitting element with high color purity.

Recently a triphenylbenzene derivative as shown in the following [Chemical Formula 6] has been developed as the wide-gap material (Japanese Patent Application Publication No. 2007-015993). The use of this material allows efficient blue phosphorescence luminescence.

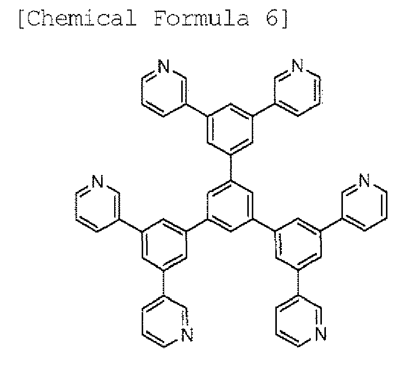

However, since the triphenylbenzene derivative as disclosed in Japanese Patent Application Publication No. 2007-015993 includes a pyridine ring with fewer electrons, its Ig (ionization potential) and Eg (electron affinity) are large, and its electronic transport ability is strong. For this reason, when it is used as a wide-gap host material of a light emitting layer, a hole is blocked, and it is expected that is difficult to inject holes corresponding to electrons and to aim at balancing Ig with Eg of a blue luminescent material.

### SUMMARY OF THE INVENTION

The present invention arises in order to solve the above-mentioned technical problem, and aims at finding a triphenylbenzene derivative which is suitable for a wide-gap material allowing blue luminescence excellent in color purity, and providing an organic EL element using the same.

The organic EL element in accordance with the present invention is an organic EL element having one or a plurality of organic layers including a light emitting layer between a pair of electrodes, characterized in that at least one layer of the above-mentioned organic layers contains a compound as expressed by the following general formula (1) independently or as a mixture.

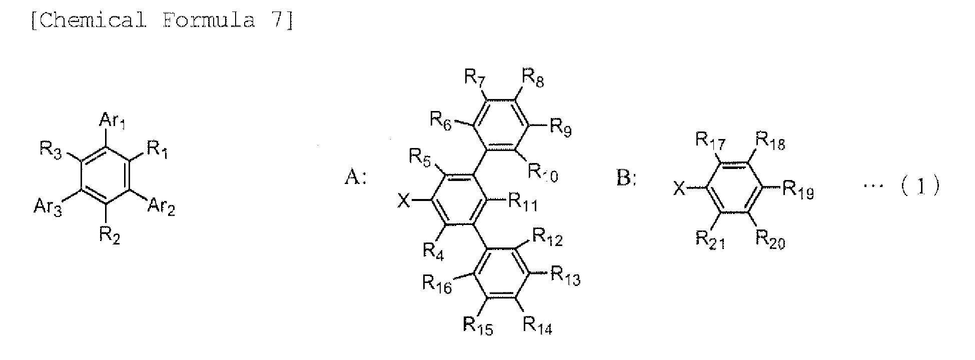

In the above-mentioned general formula (1), R₁-R₂₁ are substituents which are each independently selected from the group consisting of hydrogen, an alkyl group, a cycloalkyl group, an alkoxy group, a cycloalkoxy group, an aryloxy group, and an alkylsilyl group. Each of Ar₁-Ar₃ is A or B independently, and at least one of them is A. X indicates a bond part with respect to a central benzene ring, and is bonded in a meta position with respect to the central benzene ring.

By using such a compound as the organic EL material, it is possible to constitute an element which allows blue luminescence excellent in color purity.

In the above-mentioned organic EL element, it is preferable that at least one layer of the above-mentioned organic layers is a light emitting layer containing the compound expressed by the above-mentioned general formula (1) as a host material and a fluorescence or phosphorescence material as a guest material.

Further, a hole injection transport layer having an area where an oxidizing dopant as a hole injection transport material is mixed with the compound expressed by the above-mentioned general formula (1) may be provided between a first electrode and the light emitting layer.

The compound expressed by the above-mentioned general formula (1) can also be used for the hole injection transport layer by reaction with the oxidizing dopant.

Further, an electron injection transport layer having an area where the compound expressed by the above-mentioned general formula (1), as an electron injection transport material, is mixed with a reducing dopant may be provided between a second electrode and the light emitting layer.

The compound expressed by the above-mentioned general formula (1) can also be used for the electron injection transport layer by reaction with the reducing dopant.

It is preferable that the above-mentioned oxidizing dopant is zincoxide, aluminumoxide, tungsticoxide, vanadiumoxide, rheniumoxide, molybdenum oxide, or ruthenium oxide.

Further, as for the above-mentioned electrode, it is preferable that a transparent electroconductive thin-film is formed on a transparent substrate.

As described above, according to the organic EL element in accordance with the present invention, the blue luminescence excellent in color purity is obtained. Thus, it is possible to provide the white-light emitting element with high color rendering properties.

Therefore, it is expected that the organic EL element in accordance with the present invention would be applied to flat panel displays for OA computers and flat TV sets which nowadays require better color reproducibility, a light source for an illumination apparatus, a light source for a copying machine, light sources which take advantage of planar light-emitting member, such as backlight sources for a liquid crystal display, meters, etc., a display board, and a beacon light.

### BRIEF DESCRIPTION OF THE DRAWINGS

FIG. 1 is a sectional view schematically showing a layer structure of an organic EL element in accordance with Example 2.
FIG. 2 is a graph showing a light emission spectrum of the organic EL element in accordance with Example 2.
FIG. 3 is a graph showing a light emission spectrum of an organic EL element in accordance with Example 4.
FIG. 4 is a graph showing a light emission spectrum of an organic EL element in accordance with Comparative Example 1.
FIG. 5 is a graph showing a light emission spectrum of an organic EL element in accordance with Example 5.

### DESCRIPTION OF THE PREFERRED EMBODIMENTS

Hereafter, the present invention will be described in detail.

A wide-gap material used for an organic EL element in accordance with the present invention is a compound expressed by the above-mentioned general formula (1).

Such a m-phenylene derivative is a compound which allows a blue luminescent material to emit light with high color purity. By using this, it is possible to provide a white light emitting element with high color rendering properties.

In the above-mentioned general formula (1) , R₁-R₂₁ are substituents which are each independently selected from the group consisting of hydrogen, an alkyl group, a cycloalkyl group, an alkoxy group, a cycloalkoxy group, an aryloxy group, and an alkylsilyl group. Each of Ar₁-Ar₃ is A or B independently, and at least one of them is A. X indicates a bond part with respect to a central benzene ring, and is bonded in a meta position with respect to the central benzene ring.

Among the above-mentioned substitution groups, the alkyl group indicates a saturated aliphatic hydrocarbon group, preferably having 1 to 6 carbon atoms, more preferably 1 to 4 carbon atoms, such as for example, a methyl group, an ethyl group, a propyl group, a butyl group, etc., and it may be of a straight chain or may be of a branched chain.

The cycloalkyl group indicates a saturated alicyclic hydrocarbon group, preferably having 3 to 10 carbon atoms, more preferably 5 to 8 carbon atoms, such as for example, a cyclohexyl group, a norbornyl group, an adamantyl group, etc., and they may be either unsubstituted or substituted.

The alkoxy group indicates, for example, a saturated aliphatic hydrocarbon group through ether bonds, wherein the saturated aliphatic hydrocarbon group is preferably an alkyl group as defined above, such as a methoxy group etc., and it may be of a straight chain, or may be of a branched chain.

The cycloalkoxy group indicates a cyclic saturated aliphatic hydrocarbon group through ether bonds, wherein the cyclic saturated aliphatic hydrocarbon group is preferably a cycloalkyl group as defined above, such as for example, a cyclohexyloxy group etc., and it may be either unsubstituted or substituted.

The aryloxy group indicates an aromatic hydrocarbon group through ether bonds, such as for example a phenoxy group etc., and the aromatic hydrocarbon group may be either unsubstituted or substituted, and has preferably 6 to 14 carbon atoms, more preferably 6 to 10 carbon atoms.

The alkylsilyl group indicates a saturated aliphatic hydrocarbon group, wherein the saturated aliphatic hydrocarbon group is preferably an alkyl group as defined above, such as a trimethylsilyl group, a triethylsilyl group, etc., and it may be of a straight chain, or may be of a branched chain.

The substituted phenyl group indicates a phenyl group substituted with an alkyl group, a cycloalkyl group, an alkoxy group, a cycloalkoxy group, or an aryloxy group.

The substituted or unsubstituted phenyl group is bonded in a meta position with respect to the central benzene ring.

Hereafter, among the compounds expressed by the above-mentioned general formula (1), a structure of a particular compound in which Ar₁=A, Ar₂=B, and Ar₃=B will be illustrated below.

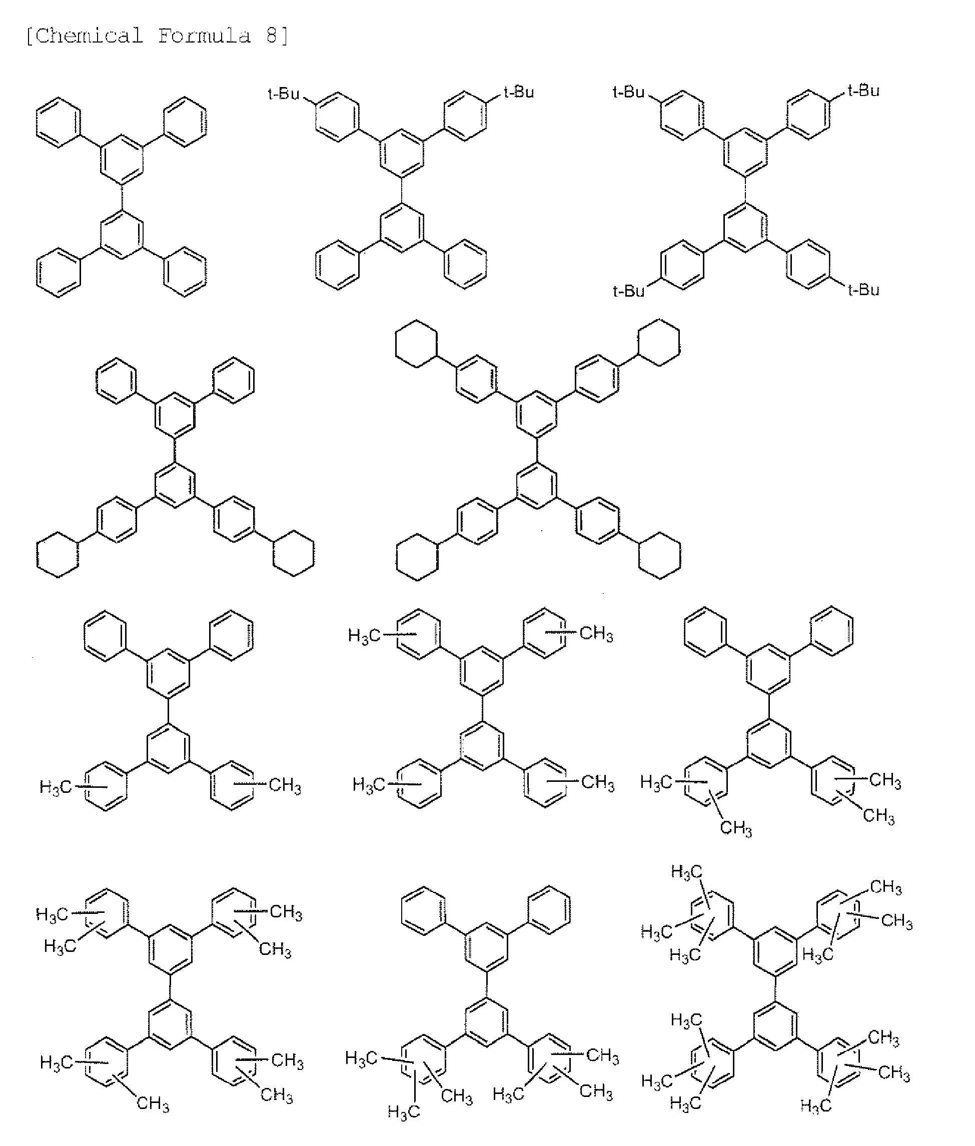

Further, a structure of a particular compound in which Ar₁=A, Ar₂=A, and Ar₃=B will be illustrated below. In addition, X in each compound as shown in the following [Chemical Formula 9] is combined with X of either the unsubstituted or substituted phenyl group as shown in the following [Chemical Formula 10].

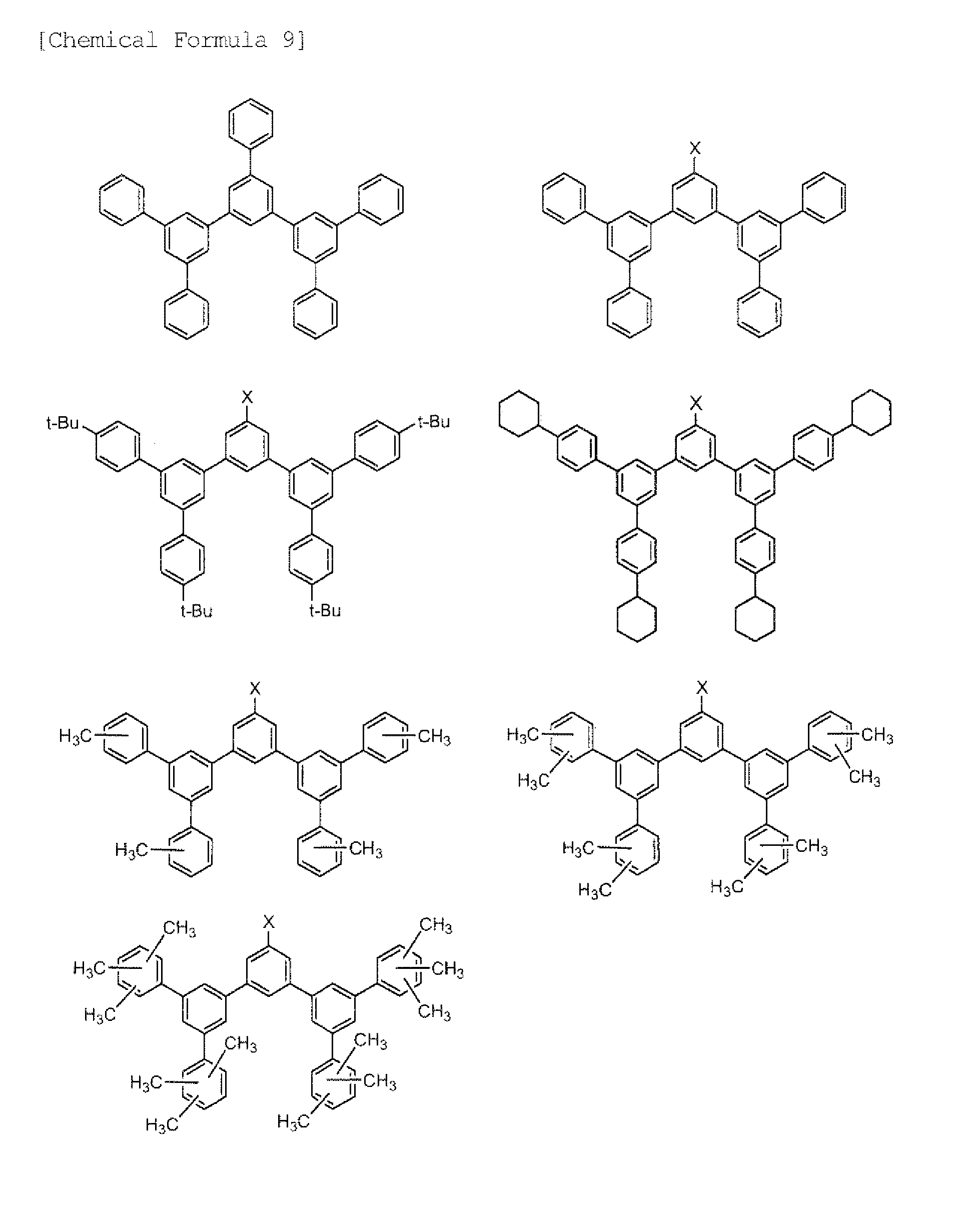

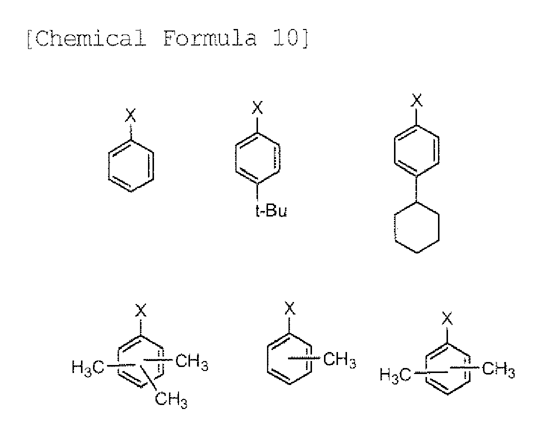

Further, a structure of a particular compound in which Ar₁=A, Ar₂=A, and Ar₃=A will be illustrated below. In addition, X in each compound as shown in the following [Chemical Formula 11] is combined with X of either the unsubstituted or substituted phenyl group as shown in the following [Chemical Formula 12].

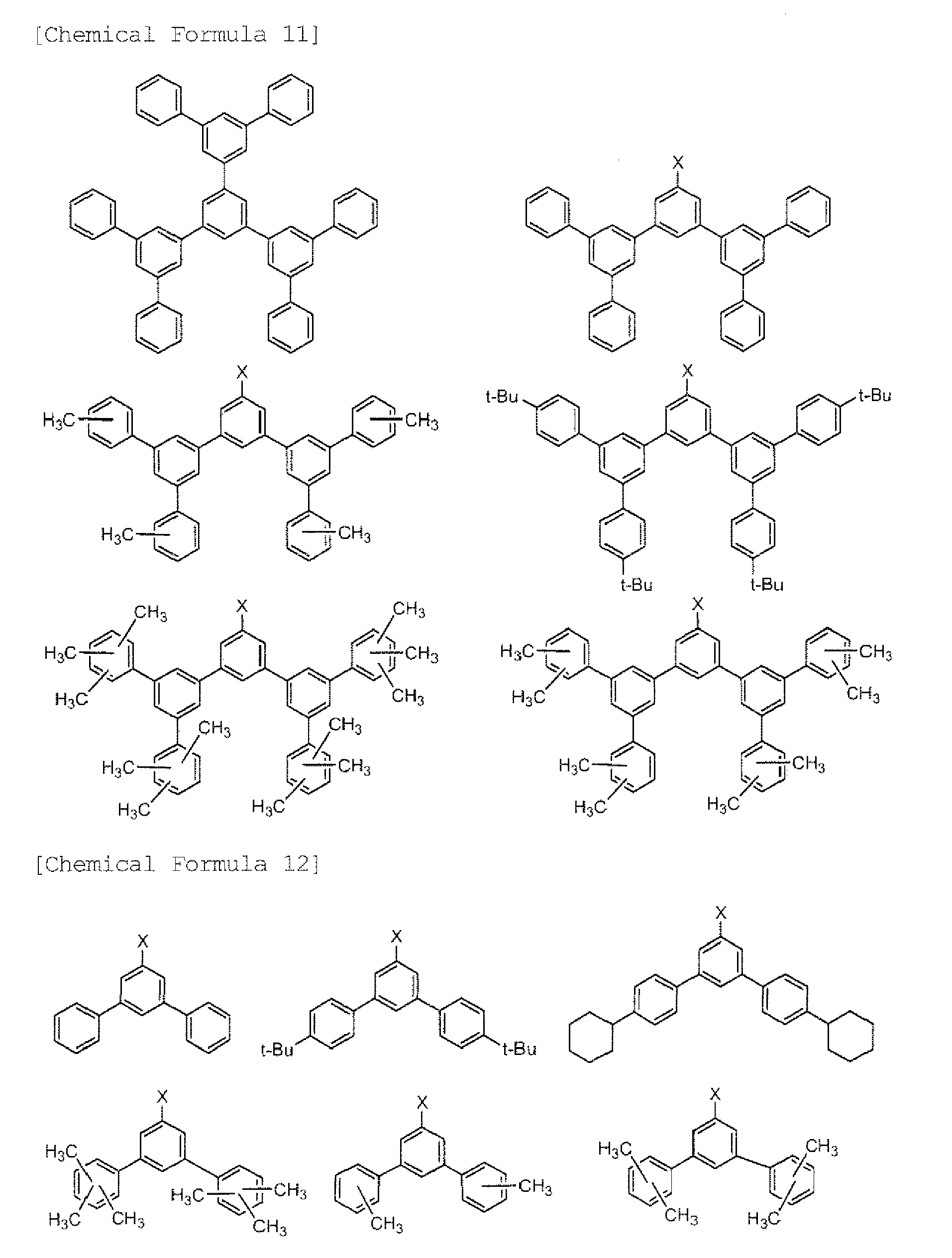

The compound expressed by the above-mentioned general formula (1) may be synthesized by way of a conventional known synthetic reaction. For example, a desiredm-phenylene derivative as synthesized in accordance with Japanese Patent Application Publication No. 2004-534865 may be reacted with corresponding phenylboric acid by means of transition metal catalysts, such as Ni, Pd, etc., to obtain a precursor of the desired m-phenylene derivative.

As described above, the organic EL element having the layer containing an organic EL material which emits blue light excellent in color purity in accordance with the present invention is arranged such that one or a plurality of organic layers are laminated between electrodes. As particular examples of the structure, there may be mentioned "first electrode / light emitting layer / second electrode", "first electrode / hole transport layer / light emitting layer / electron transport layer / second electrode", "first electrode / hole transport layer / light emitting layer / second electrode", "first electrode / light emitting layer / electron transport layer / second electrode", etc.

Further, it is also possible to employ the known lamination structure further including a hole injection layer, a hole transport light-emitting layer, an electron injection layer, an electron transport light-emitting layer, etc.

The compound which is expressed by the above-mentioned general formula (1) and is the organic EL material in accordance with the present invention may be used for any of the above-mentioned organic layers, and may be used and dispersed together with a hole transport material, a light emitting material, and an electron transport material. Further, the dispersion may be doped with a light emitting colorant.

Furthermore, the compound expressed by the above-mentioned general formula (1) can also be used for a hole injection transport layer by reaction with an oxidizing dopant, and for an electron injection transport layer by reaction with a reducing dopant.

As for the electrode of the organic EL element in accordance with the present invention, it is preferable that a transparent electroconductive thin-film is formed on a transparent substrate.

The above-mentioned substrate is a support member of the organic EL element. In the case where the substrate side is a light emitting side, it is preferable to use a transparent substrate which is transmissive in visible light. It is preferable that the optical transmissivity is 80% or more. More preferably, it is 85% or more. Most preferably, it is 90% or more.

In general, the above-mentioned transparent substrate employs glass substrates made of, such as for example, optical glass (BK7, BaK1, F2, etc.), silica glass, non alkali glass, borosilicate glass, aluminosilicate glass, polymer substrate made of, such as for example, acrylic resins (PMMA, etc.), polycarbonate, polyether sulphonate, polystyrene, polyolefin, an epoxy resin, and polyethylene terephthalate, polyester, etc.

Although the above-mentioned substrate having a thickness of approximately 0.1-10 mm is usually used, it is preferable that the thickness is 0.3-5 mm in view of mechanical strength, weight, etc. More preferably, it is 0.5-2 mm.

Further, in the present invention, it is preferable that the first electrode is provided on the above-mentioned substrate. Although this first electrode is usually an anode and is made of a metal, an alloy, an electroconductive compound, etc., with a large work function (4 eV or more), it is preferable to be formed as a transparent electrode on the above-mentioned transparent substrate.

In general, metal oxides, such as indium tin oxide (ITO), indium zinc oxide, and zinc oxide, etc., are used for this transparent electrode. In particular, ITO is preferably used in terms of its transparency, conductivity, etc.

In order to secure the transparency and conductivity, it is preferable that a film thickness of this transparent electrode is 80-400 nm. More preferably, it is 100-200 nm.

It is preferable that the anode is usually formed by way of a sputtering method, a vacuum deposition method, etc., and formed as the transparent electroconductive thin-film.

On the other hand, in the case where the above-mentioned anode is the first electrode, a cathode of the second electrode which faces this anode is made of a metal, an alloy, and a conductive compound having a small work function (4 eV or less). As examples thereof, there may be mentioned aluminum, an aluminum-lithium alloy, a magnesium-silver alloy, etc.

It is preferable that the film thickness of the above-mentioned cathode is 10-500 nm. More preferably, it is 50-200 nm.

The above-mentioned anode and cathode can be formed by forming a film by way of methods usually used, such as a sputtering method, an ion plating method, a vapor-depositing method, etc.

Respective materials used for the above-mentioned hole injection layer, hole transport layer, and hole transport light-emitting layer are not particularly limited, but can be suitably selected from known materials to use.

In particular, they may be arylamine derivatives, such as bis(di(p-trill)aminophenyl)-1,1-cyclohexane (common name: TAPc), Spiro-TPD [Chemical Formula 13], N,N'-diphenyl-N,N'-bis(3-methylphenyl)-1,1'-biphenyl- 4,4'-diamine (common name: TPD), N,N'-diphenyl-N,N'-bis(1-naphthyl)-1,1'-biphenyl-4,4'-diamine (common name: α-NPD), TPTE [Chemical Formula 14], starburst amines [Chemical Formula 15], and styrylamines [Chemical Formula 16], etc.

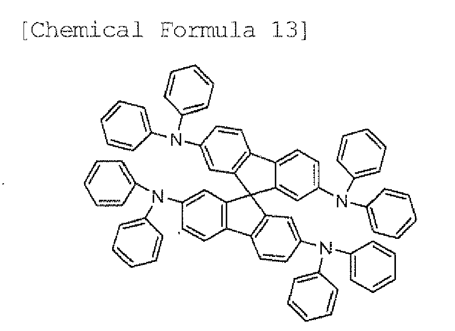

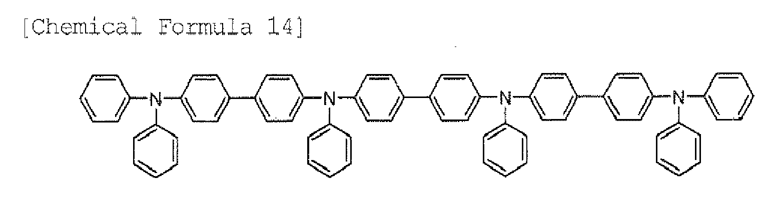

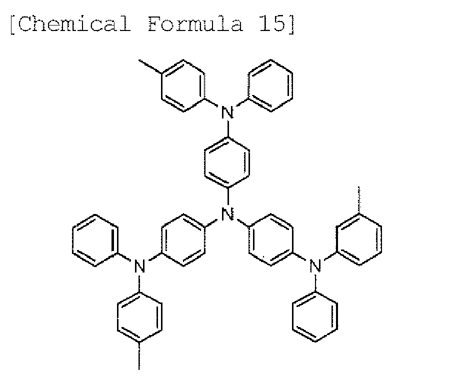

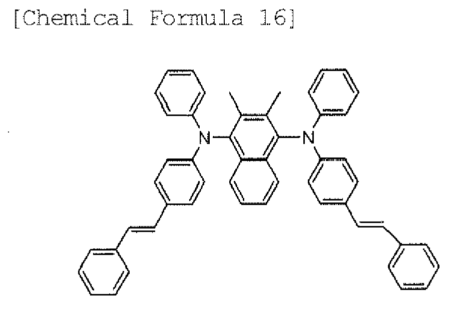

Further, it is also possible to use carbazole derivatives, such as bis(N-arylcarbazole) (common name: CBP) [Chemical Formula 17], bis(N-alkenylcarbazole), bis(N-alkylcarbazole), etc., a pyrazoline derivative, styryl compounds and their derivatives, such as [Chemical Formula 18], [Chemical Formula 19], etc.

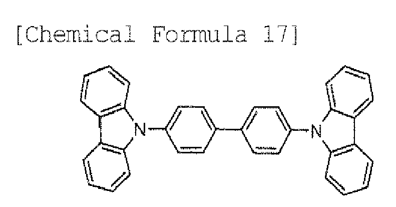

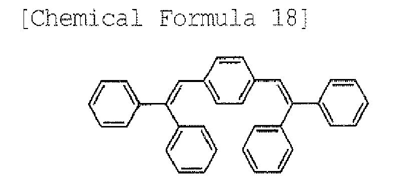

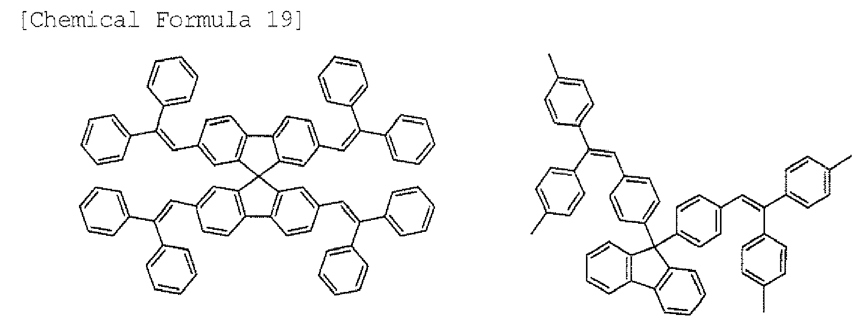

Alternatively, it is also possible to use fused multi-ring aromatic hydrocarbon compounds and their derivatives, such as anthracene, triphenylene, perylene, naphthalene, pyrene, coronene, chrysene, naphthacene, tetracene, phenanthrene, etc. as well as multi-ring compounds and their derivatives, such as paraterphenyl, quaterphenyl, m-phenylene, etc.

Further, the hole injection layer, the hole transport layer, and the hole transport light-emitting layer may employ the above-mentioned organic compound which is dispersed in a polymer, an oligomer, or a dendrimer, or which is polymerized, oligomerized or dendrimerized.

Furthermore, it is also possible to use so-called π-conjugated polymers, such as polyparaphenylenevinylene, polyfluorene, their derivatives, etc., a hole transport disconjugate polymer represented by poly(N-vinylcarbazole), σ-conjugated polymers represented by polysilanes, etc. Still further, so-called conjugated oligomers, such as for example a fluorene oligomer, its derivative, etc. can also be used.

Yet further, besides the above-mentioned materials, the hole injection layer may employ conductive polymers, such as metal phthalocyanines, non-metal phthalocyanines, carbon, film, fluorocarbon film, polystyrene sulfonic acid (PEDOT-PSS), polyaniline, etc.

Furthermore, the above-mentioned organic compound may be reacted with organic oxidizing dopants, such as tetracyanoquinodimethane, trinitrofluorenone, etc., and inorganic oxidizing dopants, such as vanadium oxide, molybdenum oxide, tungstic oxide, aluminum oxide, etc., to form a radical cation, and can be used as the hole injection transport layer. The oxidizing dopant concentration in the hole injection transport layer is not particularly limited, but it is preferable to be approximately 0.1 - 99 % by weight.

In addition, as described above, them-phenylene derivative which is expressed by the above-mentioned general formula (1) and is the organic EL material in accordance with the present invention can also be used for the hole injection transport layer by reaction with the oxidizing dopant. Preferably, the oxidizing dopant in this case is zinc oxide, aluminumoxide, tungsticoxicide, vanadiumoxide, rheniumoxide, molybdenum oxide, or ruthenium oxide.

Respective materials used for the electron injection layer, electron transport layer, and electron transport light-emitting layer are not particularly limited, but can be suitably selected from known materials to use.

As particular examples, there may be mentioned multi-ring compounds and their derivatives, such as paraterphenyl, quaterphenyl, m-phenylene, etc., and styryl compounds and their derivatives, such as [Chemical Formula 18], [Chemical Formula 19], etc.

Further, it is also possible to use fused multi-ring aromatic hydrocarbon compounds and their derivatives, such as anthracene, triphenylene, perylene, naphthalene, pyrene, coronene, chrysene, naphthacene, tetracene, phenanthrene, etc., as well as heterocyclic compounds and their derivatives, such as phenanthroline, bathophenanthroline, bathocuproin, phenanthridine, acridine, quinoline, quinoxaline, pyridine [Chemical Formula 20], pyrimidine, pyrrole, pyrazole, pyridazine, pyrazine, phthalazine, naphthylidine,quinazoline, cinnoline, thiazole, oxadiazole, oxazole, triazine, phenazine, imidazole, benzoxazole, benzothiazole benzoimidazole, triazole, porphyrin, etc.

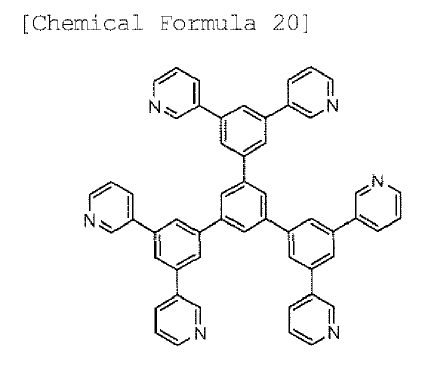

Further, it is al sopossible to usemetal chelate complexmaterials, for example, a quinolinol aluminum complex, a benzoxazole zinc complex, a benzothiazole zinc complex, an azomethine zinc complex, a europium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands.

It is also possible to use organosilicon compounds and their derivatives, such as silole, siloxane, etc., organic boron compounds and their derivatives, such as triarylborane etc., and pentavalent phosphorus compounds and their derivatives etc, such as triarylphosphoxide etc.

Furthermore, the electron injection layer, the electron transport layer, and the electron transport light-emitting layer may employ the above-mentioned organic compound which is dispersed in a polymer, an oligomer, or a dendrimer, or which is polymerized, oligomerized or dendrimerized.

Further, it is also possible to use the so-called π-conjugated polymers, such as polyparaphenylenevinylene, polyfluorene, their derivatives, etc., and the electron transport disconjugate polymers etc. represented by polyvinyl oxadiazole. Furthermore, so-called conjugated oligomers etc., such as a fluorene oligomer, its derivative, etc. can also be used.

Besides the above-mentioned organic compounds, as the constituent material of the electron injection layer, it is possible to use single metals, such as Ba, Ca, Li, Cs, Mg, Sr, W, etc., metal fluorides, such as magnesium fluoride, calcium fluoride, strontium fluoride, barium fluoride, lithium fluoride, cesium fluoride, etc., metal alloys, such as an aluminum lithium alloy etc., metal oxides, such as magnesium oxide, strontium oxide, aluminum oxide, etc., and organometallic complexes, such as sodium polymethylmethacrylate polystyrene sulfonate etc.

Furthermore, the above-mentioned organic compound may be reacted with an organic reducing dopant, such as 8-hydroxyquinoline Cs, Li organometallic complex, etc., to form a radical anion, which can be used as the electron injection transport layer.

Further, single metals, such as Ba, Ca, Li, Cs, Mg, Sr, W, etc., metal oxides, such as magnesium oxide, strontium oxide, aluminum oxide, etc., metal salts, such as magnesium fluoride, calciumfluoride, strontium fluoride, barium fluoride, lithium fluoride, cesium fluoride, cesium chloride, strontium chloride, etc. , and inorganic reducing dopants may be mixed or dispersed to form a radical anion, which can be used as the electron injection transport layer.

Although the reducing dopant concentration in the above-mentioned electron injection transport layers is not particularly limited, it is preferable to be approximately 0.1 - 99 % by weight.

In addition, as described above, the m-phenylene derivative which is expressed by the above-mentioned general formula (1) and is the organic EL material in accordance with the present invention can also be used as the electron injection transport layer by reaction with the reducing dopant.

Further, it is possible to constitute the organic layer of the organic EL element in accordance with the present invention by using a bipolar material. By bipolar material is meant a material which can convey both the hole and the electron and may emit light by itself.

The material used for the bipolar transport layer and a bipolar light-emitting layer is not particularly limited.

As examples thereof, there may be mentioned styryl compounds and their derivatives, such as [Chemical Formula 18], [Chemical Formula 19], etc., multi-ring aromatic compounds and their derivatives, such as paraterphenyl, quaterphenyl, m-phenylene, etc., fused multi-ring aromatic hydrocarbon compounds and their derivatives, such as anthracene, triphenylene, perylene, naphtalene, pyrene, coronene, chrysene, naphthacene, tetracene, phenanthrene, etc., carbazole derivatives [Chemical Formula 17], such as bis(N-arylcarbazole), bis (N-alkenylcarbazole), bis (N-alkylcarbazole), etc., and heterocyclic compounds, such as thiophene etc.

Further, as particular examples other than these derivatives etc., there may be mentioned 4,4-bis(2,2-diphenyl-ethene-1-yl)diphenyl (common name: DPVBi) [Chemical Formula 21], spiro6 [Chemical Formula 22], 2,2',7,7'-tetrakis(carbazole-9-yl)-9,9'-spiro-bifluorene [Chemical Formula 23], 4,4'-di(N-carbazolyl)-2',3',5',6'-tetraphenyl-p-terphenyl [Chemical Formula 24], 1,3-bits (carbazole)-9-yl-benzene [Chemical Formula 25], and 3-tert-butyl-9,10-di(naphtha-2-yl)anthracene (common name: TBADN) [Chemical Formula 26].

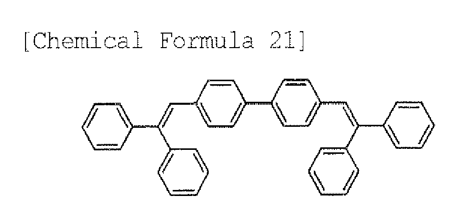

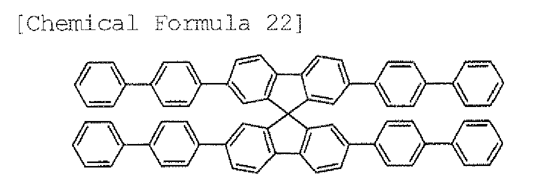

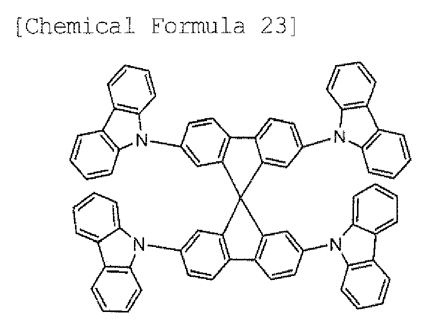

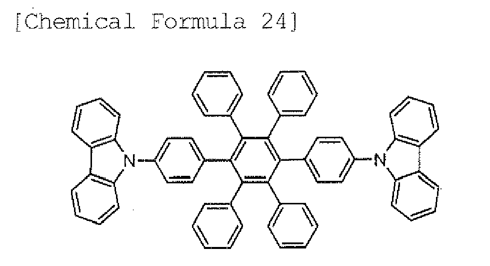

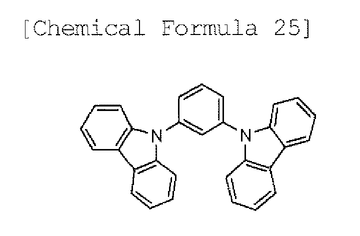

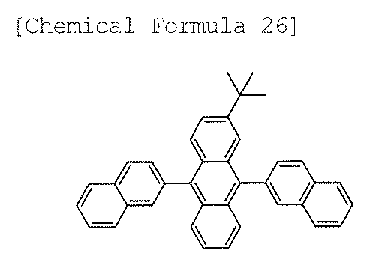

The bipolar material may employ the above-mentioned organic compound which is dispersed in a polymer, an oligomer, or a dendrimer, or which is polymerized, oligomerized or dendrimerized.

Further, it is also possible to use the so-called π-conjugated polymers, such as polyparaphenylene vinylene, polyfluorene, their derivatives, etc., and disconjugate polymers etc. represented by polyvinylcarbazole. Furthermore, so-called conjugated oligomers etc., such as a fluorine oligomer, its derivative, etc. can also be used.

Further, copolymers, such as poly(vinyltriarylaminevinyloxadiazole) etc., where monomers having a hole transport function and an electron transport function exist in the same molecule, and a dendrimer can also be used.

Furthermore, it is possible to use the above-mentioned bipolar material which is reacted with the oxidizing dopant or reducing dopant as described above to form the hole injection layer or the electron injection layer. Especially, it is preferable that the oxidizing dopant is molybdenum oxide or vanadium oxide.

Although the organic EL material expressed by the above-mentioned general formula (1) can be used for the light emitting layer independently, it may be dispersed together with other hole transport material, light emitting material, electron transport material, etc., or doped, and can also be used combining with any of the above-mentioned organic layers.

In the organic EL element in accordance with the present invention, it is especially preferable that the blue luminescent material is used as a guest material to form the light emitting layer where the organic EL material expressed by the above-mentioned general formula (1) is included as a host material.

In the case where the organic EL material expressed by the above-mentioned general formula (1) is used as the host material of the light emitting layer, the guest material of the light emitting layer may be a fluorescence or phosphorescence emitting material.

As examples thereof, there may be mentioned multi-ring compounds and their derivatives, such as paraterphenyl, quaterphenyl, styryl compounds [Chemical Formula 18], [Chemical Formula 19], etc., and their derivatives, a tetraphenyl butadiene derivative, a pyrazoline derivative, an oxadiazole derivative, a coumarin derivative, a styrylamine derivative [Chemical Formula 16], and fused multi-ring aromatic hydrocarbon compounds and their derivatives, such as anthracene [Chemical Formula 27], triphenylene, perylene, naphthalene [Chemical Formula 28] (common name: TPN1458), pyrene, coronene, chrysene, naphthacene, tetracene, phenanthrene, etc.

Further, it is also possible to use metal chelate complex materials for example, a quinolinol aluminum complex, a benzoxazole zinc complex, a benzothiazole zinc complex, an azomethine zinc complex, a europium complex, a terbium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands. In particular, the metal chelate complexes represented by FIrpic [Chemical Formula 29] and their derivatives are mentioned.

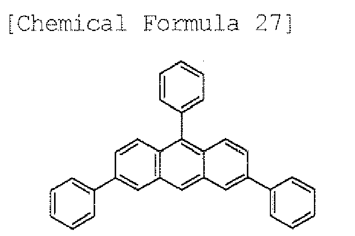

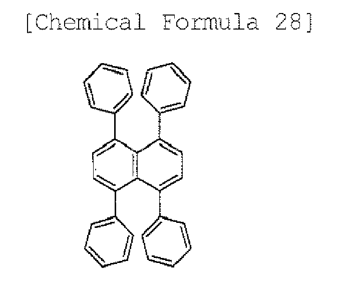

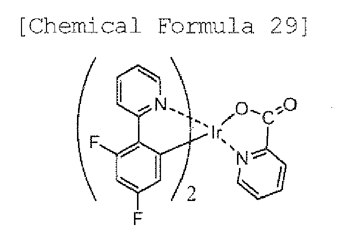

In addition, the light emitting layer may be made of the bipolar material as described above. The organic EL material expressed by the above-mentioned general formula (1) is included in the layer formed of the bipolar material independently or as a mixture, so that blue luminescence can also be obtained.

The bipolar material used for this light emitting layer may be a material which emits fluorescence or phosphorescence by itself. The bipolar material may be contained in any of the hole injection transport layer, the light emitting layer, and the electron injection transport layer.

The formation of each of the above-mentioned organic layers can be performed by way of dry processes, such as a vacuum deposition process, a sputtering process, etc., and wet processes, such as an ink-jet process, a casting process, a dip coat process, a bar coat process, a blade coat process, a roll coat process, a photogravure coat process, a flexographic printing process, a spray coat process, etc. Preferably, the film formation is carried out by vacuum deposition.

Further although a film thickness of each of the above-mentioned layers is suitably determined depending on its conditions in view of adaptability between the respective layers, the whole layer thickness to be required, etc. , it is usually preferable to be within a range from 5 nm to 5 µm.

In the organic EL element provided with the layer containing the organic EL material expressed by the above-mentioned general formula (1) independently or as a mixture, the blue luminescence having high color purity and provided by the organic EL material expressed by the above-mentioned general formula (1) is combined with green and red luminescence so that white luminescence with high color-rendering properties may be obtained.

As a particular method of obtaining white luminescence with high color-rendering properties, there may be mentioned a method of adding green luminescence and yellow to orange luminescence to the blue luminescence by the organic EL material expressed by the above-mentioned general formula (1) as complementary colors, a method of causing each of the blue, green, and red luminescent materials containing the material expressed by the above-mentioned general formula (1) to emit light independently, etc.

The above-mentioned green luminescent material or the red luminescent material may be a fluorescence or phosphorescence emitting material.

As examples thereof, there may be mentioned a quinacridone derivative, a squarylium derivative, a porphyrin derivative, a coumarin derivative, a dicyanopyrane derivative, arylamine compounds and their derivatives, such as anthracenediamine etc., fused multi-ring aromatic hydrocarbon compounds and their derivatives, such as perylene, rubrene, tetracene, decacyclene, etc., phenoxazone, a quinoxaline derivative, a carbazole derivative, and a fluorene derivative.

Further, it is also possible tousemetal chelate complex materials, for example, a quinolinol aluminum complex, a benzoxazole zinc complex, a benzothiazole zinc complex, an azomethine zinc complex, a europium complex, a terbium complex, an iridium complex, a platinum complex, etc., in which Al, Zn, Be, Ir, Pt, Tb, Eu, etc. are provided as central metals, and oxadiazole, thiadiazole, phenylpyridine, and quinoline structures are provided as ligands. In particular, the metal chelate complexes represented by Ir(ppy)₃ [Chemical Formula 30], Irpiq₃ [Chemical Formula 31] and their derivatives are mentioned.

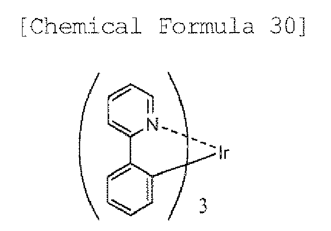

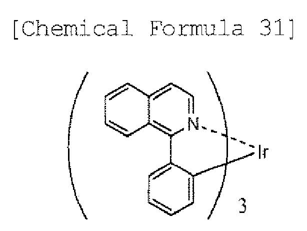

Hereafter, the present invention will be described still more particularly with reference to Examples. However, the present invention is not limited to the following Examples.

### [Example 1]

### (Synthesis of 1-(4-tert-butylphenyl)-3,5-di(3,5-di(4-tert-butylphenyl)phenyl)benz ene (common name: TPBP5))

As shown below, TPBP5 precursor synthesized with reference to Japanese Patent Application Publication No. 2004-534865 was reacted with 4-tert-butylphenylboric acid to synthesize TPBP5.

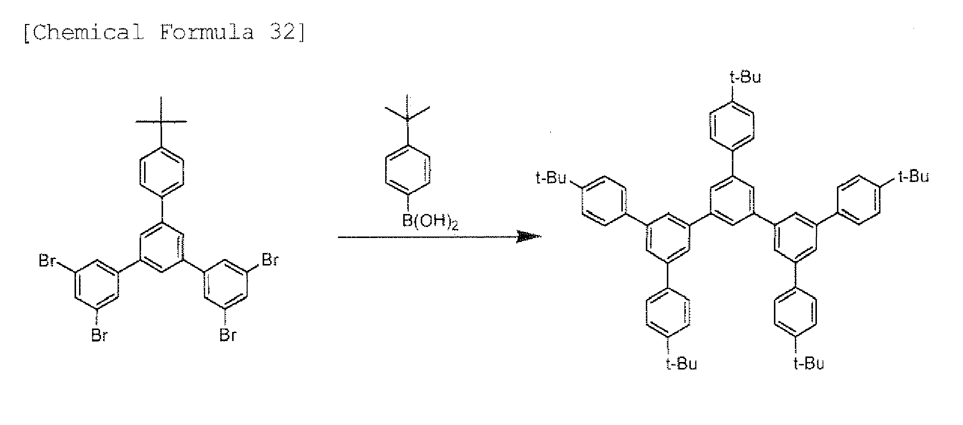

1.7 g (2.73 mmol) of 1-(4-tert-butylphenyl)-3, 5-di(3,5-dibromophenyl)benzene (which is TPBP5 precursor), 2.43g (13.7 mmol) of 4-tert-butylphenylboric acid, toluene, THF, 14ml of 2 mol/l sodium carbonate aqueous solution, and 10 mol% of Pd(PPh₃)₄ were prepared in a reaction container, and reacted together at a reflux temperature in a nitrogen atmosphere for 72 hours.

The solvent was removed after the reaction and dispersed in water. An organic component was extracted by chloroform, and a chloroform layer was washed twice with water. The chloroform layer was collected after washing to obtain a crude material. By using a mixed solvent of chloroform and n-hexane, the crude material was refined by means of a silica gel column.

The refined material was white and powdery in appearance. As a result of structural analysis by MS, ¹H-NMR, it was confirmed as the target material. Its yield was 2.2 g (83.7 % yield).

Furthermore, this material was sublimed and purified at 335 °C and 2.5 x 10⁻⁴ Pa.

### (Fluorescence Spectrum Measurement of TPBP5 Vapor-Deposition Film)

The fluorescence maximum wave length of the vapor deposition film of TPBP5 as synthesized above was 360 nm.

Since it has a shorter wavelength compared with 380 nm of fluorescence maximum wave length of the compound (CBP) as shown in the above-mentioned [Chemical Formula 17] known as a host material for phosphorescence, TPBP5 is expected as to be a wide-gap material.

### [Example 2]

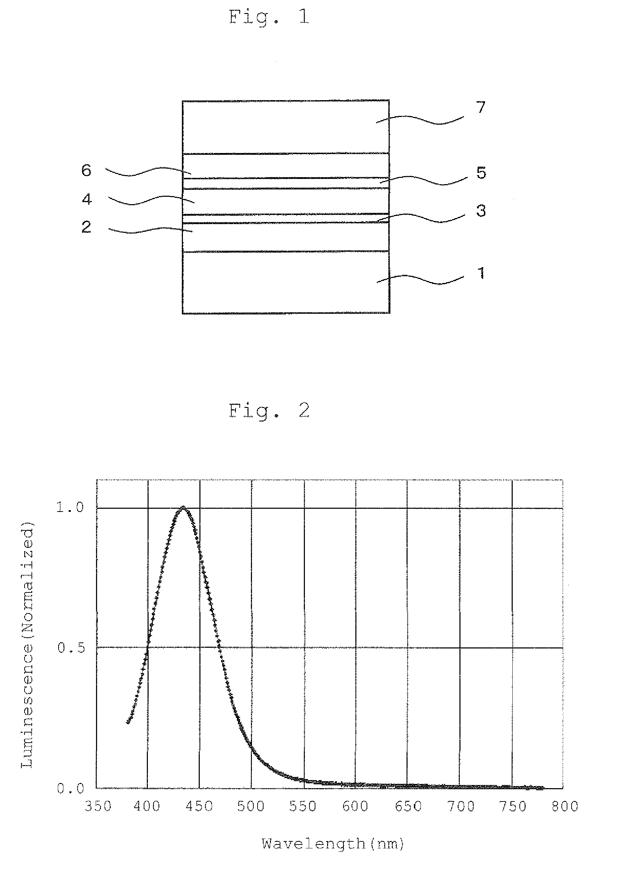

By using TPBP5 as the hole injection transport material and host material, an organic EL element having a layer structure as shown in FIG. 1 and having a light emitting layer doped with the compound. (TPN1458) as shown in the above-mentioned [Chemical Formula 28], which is a short wavelength blue luminescent material, was prepared by way of the following methods.

### (First Electrode)

First, a glass substrate having formed thereon a patterned transparent electroconductive film (ITO) with a film thickness of 150 nmwas subj ected to washing treatments in the order of ultrasonic cleaning by pure water and a surfactant, washing with flowing pure water, ultrasonic cleaning by a 1:1 mixed solution of pure water and isopropyl alcohol, and boiling washing by isopropyl alcohol. This substrate was slowly pulled up from the boiling isopropyl alcohol, and dried in isopropyl alcohol vapor, and, finally ultraviolet ozone cleaning was performed.

This substrate was used as an anode 1 and placed in a vacuum chamber which was evacuated to 1 x 10⁻⁶ Torr. In this vacuum chamber, each molybdenum boat filled up with a vapor deposition material and a vapor depositionmask for forming a film in a predetermined pattern were placed, the above-mentionedboat was electrically heated, and the vapor deposition material was evaporated to thereby form each organic layer one by one.

### (Hole Injecting Transport Layer)

Byusing TPBP5 as a hole transport material together with molybdenum trioxide (MoO₃), the respective boats were electrically heated at the same time to carry out co-deposition. A hole injection layer 2 of TPBP5:MoO₃=86:14 was formed to have a film thickness of 61 nm.

Next, a hole transport layer 3 made only of TPBP5 was formed to have a film thickness of 10 nm.

### (Light Emitting Layer)

By using TPBP5 as the host material, a light emitting layer 4 of TPBP5:TPN1458=97:3 was formed to have a film thickness of 20 nm.

### (Electron Injecting Transport Layer)

By using a compound (TPPB) as shown in the above-mentioned [Chemical Formula 21], an electron transport layer 5 was formed to have a film thickness of 10 nm, on which an electron injection layer 6 of TPPB: Cs=85:15 was formed to have a film thickness of 45 nm.

### (Second Electrode)

While maintaining the vacuum chamber at a vacuum, masks were replaced to install masks for cathode vapor deposition. An aluminum (Al) layer was formed having a film thickness of 100 nm to be a cathode 7.

The vacuum chamber was returned to ambient pressure, and the substrate on which each layer was deposited as described above was taken out, and it was moved in a glove box in which nitrogen replacement was carried out. By using a UV curing resin, it was sealed with another glass board to obtain an organic EL element.

A layer structure of this element may be simplified and shown as being ITO(150 nm) / TPBP5: MoO₃ (61 nm, 86:14) / TPBP5(10 nm) /TPBP5:TPN1458(20 nm, 97:3) / TPPB(10 nm) / TPPB:Cs (45 nm, 85:15) / Al (100nm).

A direct-current voltage of 10 V was applied to this organic EL element, then pure blue luminescence originated fromTPN1458 was obtained. A light emission spectrum of this organic EL element is shown in FIG. 2.

Further, chromaticity of this luminescence color was (x, y)=(0.155, 0.048) in CIE coordinates (100 A/m²), and it was confirmed as being blue luminescence excellent in color purity.

### [Example 3]

### (Synthesis of 1,3,5-tri (3,5-diphenyl) phenylbenzene (common name: DPPB))

As shown below, a DPPB precursor synthesized with reference to Japanese Patent Application Publication No. 2004-534865 was reacted with phenylboric acid, to synthesize DPPB.

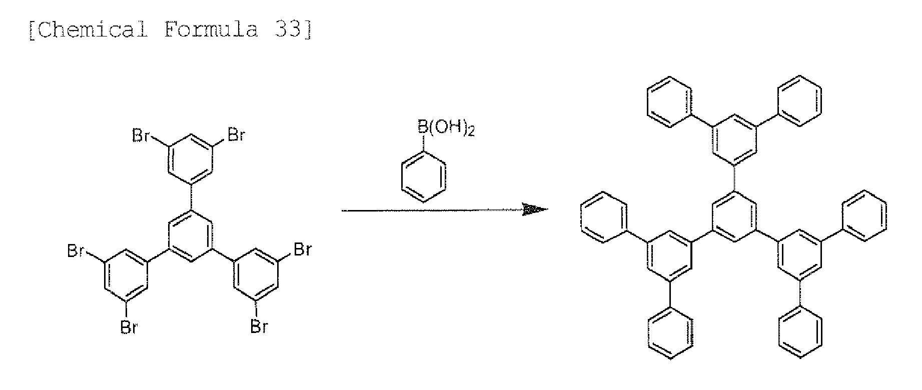

2.0 g (2.562, mmol) of tri(3,5-dibromophenyl)benzene, which is a DPPB precursor, 2.5 g (20.51 mmol) of phenylboric acid, toluene, THF, and a sodium carbonate aqueous solution were prepared in a flask in order. After carrying out nitrogen replacement in the flask, Pd(Pph₃)₄ was prepared in it and reacted together at a reflux temperature for 48 hours.

After the reaction, toluene was added, an organic component was extracted, and a toluene layer was washed twice with water. After washing, the toluene layer was collected and a crude material was obtained. By using a mixed solvent of chloroform and n-hexane, the crude material was refined by means of a silica gel column.

The refined material was white and powdery in appearance. As a result of structural analysis by MS, ¹H-NMR, it was identified as the target material. Its yield was 1.63 g (83.5 % yield).

Furthermore, this was sublimed and purified at 340 °C and 5.0 x 10⁻⁴ Pa.

### (Fluorescence Spectrum Measurement of DPPB Vapor-Deposition Film)

The fluorescence maximum wave length of the vapor deposition film of DPPB as synthesized above was 360 nm.

Since it has a shorter wavelength compared with 380 nm of fluorescence maximum wave length of the compound (CBP) as shown in the above-mentioned [Chemical Formula 17] known as the host material for phosphorescence, DPPB is expected to be a wide-gap material.

### [Example 4]

By using DPPB as the hole injection transport material and host material, an organic EL element having a layer structure as shown in FIG. 1 and having a light emitting layer doped with TPN1458 [Chemical Formula 28], which is a short wavelength blue luminescent material, was prepared similarly to Example 1.

A layer structure of this element may be simplified and shown as being ITO(150 nm) / DPPB: MoO₃ (39 nm, 84:16) / DPPB (10 nm) /DPPB:TPN1458(20 nm, 97:3) / TPPB(10 nm) / TPPB:Cs (45 nm, 85:15) / Al (100nm).

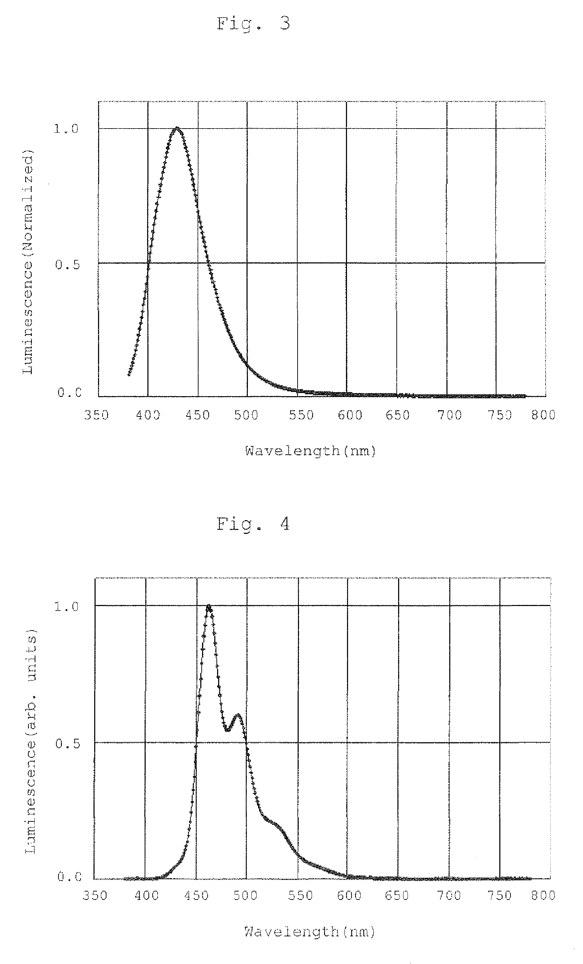

A direct-current voltage of 10 V was applied to this organic EL element, then pure blue luminescence with 1100 cd/m² originated from TPN1458wasobtained. Alight emission spectrum of this organic EL element is shown in FIG. 3.

Further, chromaticity of this luminescence color was (x, y) = ( 0.157, 0.049) in CIE coordinates (100 A/m²) and it was confirmed as being blue luminescence excellent in color purity.

### [Comparative Example 1]

TBADN [Chemical Formula 26] was employed as a host material, and the organic EL element having the light emitting layer was prepared in which a compound (TBP) as shown in the following [Chemical Formula 34] was doped.

A layer structure of this element may be simplified and shown as being ITO (150 nm) / CuPc (20 nm) / NPD (40 nm) / TBADN:TBP (35 nm, 99.15:0.85) / BAlq (12 nm) / Alq (20 nm) / LiF / Al (100 nm).

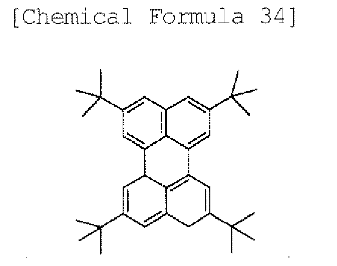

A direct-current voltage of 10 V was applied to this organic EL element, luminescence of light blue with 2000 cd/m² was obtained. Further, a light emission spectrum of this organic EL element is shown in FIG. 4.

Further, chromaticity of this luminescence color was (x, y)=(0.15, 0.19) in CIE coordinates (100 A/m²), and color purity of the blue luminescence was low.

As described above, according to the organic EL element using the compound as expressed by the general formula (1) in accordance with the present invention, it was confirmed that the blue luminescence excellent in color purity was obtained.

Further, it was confirmed that it was available for the hole injection layer by providing the layer doped with the oxidizing dopant and containing the compound as expressed by the general formula (1) .

Therefore, it is expected that the organic EL element in accordance with the present invention would be applied to a light source and a display element in which excellent color purity is required.

### [Example 5]

A blue phosphorescence emitting element was prepared by using DPPB as a host material and Flrpic [Chemical Formula 29], which provides blue phosphorescence luminescence, as a guest material.

A layer structure of this element may be simplified and shown as being ITO (150 nm) / polymer layer (20 nm) / TPAc(20 nm) / DPPB:FIrpic (10 nm, 55:45) / TPPB (65 nm) / LiF (5 nm) / Al (100 nm).

In addition, TPAc is a compound as shown in the following [Chemical Formula 35], and the above-mentioned polymer layer is such that 10 % by weight of a compound (TBPAH) as shown in the right of the following [Chemical Formula 36] is dispersed in a compound (PTPDES) as shown in the left.

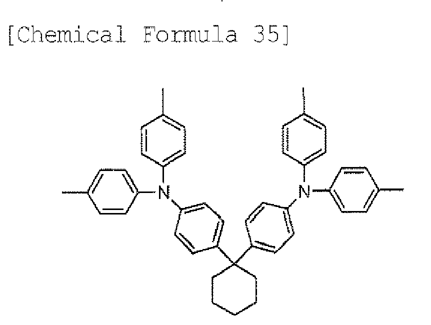

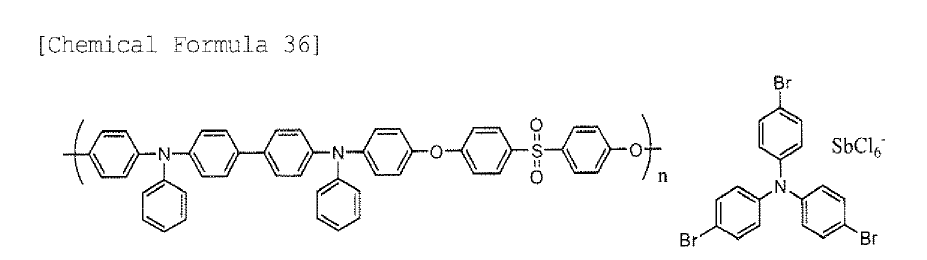

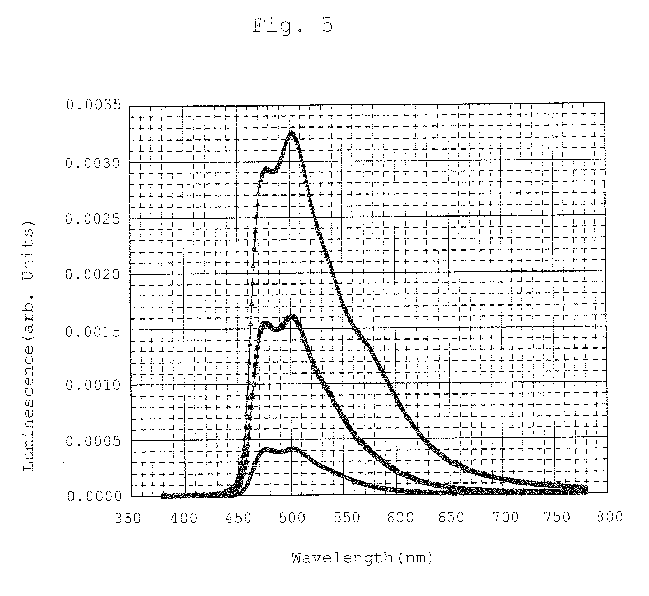

A light emission spectrum of this element is shown in FIG. 5.

### [Comparative Example 2]

Except for and instead of DPPB in Example 5, a compound (CzTT) as shown in the following [Chemical Formula 37] was used as a host material, and a blue phosphorescence emitting element was prepared similarly to Example 5.

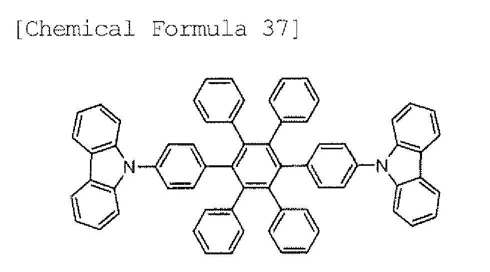

A layer structure of this element may be simplified and shown as being ITO (150 nm) / polymer layer (20 nm) / TPAc(20 nm) / CzTT: FIrpic (10 nm, 94:6) / TPPB (65 nm) / LiF (5 nm) / Al (100 nm).

Data of the elements prepared in Example 5 and Comparative Example 2 are collectively shown in the following Table 1.

**[Table 1]**

| | Voltage (V) | Front Luminosity (cd/m²) | External Quantum Efficiency (%) | Visual Luminous Efficiency (lm/W) | Current Density (A/m²) |
|---|---|---|---|---|---|
| Example 5 | 4.1 | 116 | 10.7 | 19.1 | 4.5 |
| Comparative Example 2 | 4.2 | 148 | 6.6 | 10.9 | 10.0 |

As shown in the element data of Table 1, it is confirmed that the use of DPPB as the host material of the blue phosphorescence emitting element improves the luminous efficiency compared with the element using CzTT.

Therefore, it is confirmed that the compound expressed by the general formula (1) in accordance with the present invention is useful as the host material of the blue phosphorescence emitting element, and the element using this compound provides blue phosphorescence luminescence with high efficiency.

## Claims

1. An organic electroluminescence element having one or a plurality of organic layers including a light emitting layer between a pair of electrodes, wherein at least one layer of said organic layers contains a compound expressed by the following general formula (1) independently or as a mixture, 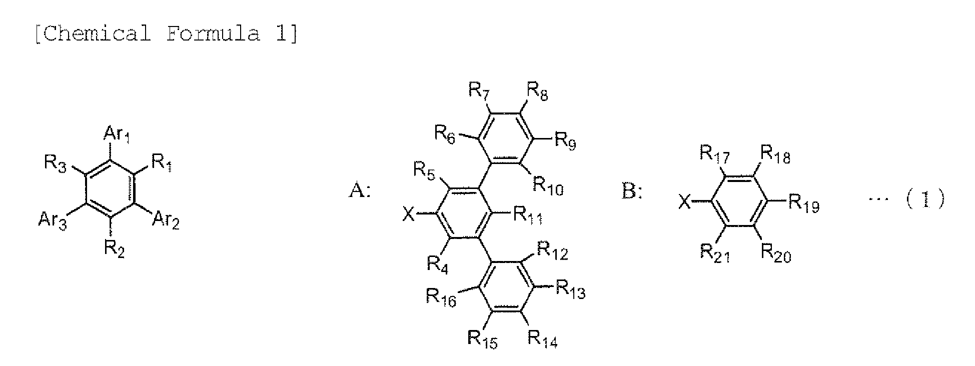 where R₁-R₂₁ are substituents which are each independently selected from the group consisting of hydrogen, an alkyl group, a cycloalkyl group, an alkoxy group, a cycloalkoxy group, an aryloxy group, and an alkylsilyl group, each of Ar₁-Ar₃ is A or B independently, at least one of them is A, and X indicates a bond part with respect to a central benzene ring and is bonded in a meta position with respect to the central benzene ring.

2. The organic electroluminescence element as claimed in claim 1, wherein at least one layer of said organic layers is the light emitting layer containing a compound expressed by said general formula (1) as a host material, and a fluorescence or phosphorescence material as a guest material.

3. The organic electroluminescence element as claimed in claim 1, wherein a hole injection transport layer having an area where an oxidizing dopant as a hole injection transport material is mixed with the compound expressed by said general formula (1) is provided between a first electrode and the light emitting layer.

4. The organic electroluminescence element as claimed in claim 1, wherein an electron injection transport layer having an area where a reducing dopant as an electron injection transport material is mixed with the compound expressed by said general formula (1) is provided between a second electrode and the light emitting layer.

5. The organic electroluminescence element as claimed in claim 3, wherein said oxidizing dopant is zinc oxide, aluminum oxide, tungstic oxide, vanadium oxide, rhenium oxide, molybdenum oxide, or ruthenium oxide.

6. The organic electroluminescence element as claimed in claim 1, wherein said electrode is such that a transparent electroconductive thin-film is formed on a transparent substrate.
